(19) **Europäisches Patentamt / European Patent Office / Office européen des brevets**

(11) **EP 1 330 715 B1**

(12) **EUROPEAN PATENT SPECIFICATION**

(45) Date of publication and mention
of the grant of the patent:
**02.01.2008 Bulletin 2008/01**

(21) Application number: **01976857.1**

(22) Date of filing: **26.10.2001**

(51) Int Cl.:
*G06F 12/02* (2006.01)      *G11C 16/00* (2006.01)

(86) International application number:
**PCT/JP2001/009459**

(87) International publication number:
**WO 2002/035548 (02.05.2002 Gazette 2002/18)**

(54) **STORING DEVICE, STORING CONTROL METHOD AND PROGRAM**

SPEICHERVORRICHTUNG, SPEICHERSTEUERVERFAHREN UND PROGRAMM

DISPOSITIF DE STOCKAGE, PROCEDE DE COMMANDE DE STOCKAGE ET PROGRAMME

(84) Designated Contracting States:
**DE FR GB**

(30) Priority: **26.10.2000 JP 2000326472**

(43) Date of publication of application:
**30.07.2003 Bulletin 2003/31**

(73) Proprietor: **MATSUSHITA ELECTRIC INDUSTRIAL CO., LTD**
**Kadoma-shi, Osaka 571-0050 (JP)**

(72) Inventors:
• **OTAKE, Toshihiko**
**Nishinomiya-shi, Hyogo 662-0095 (JP)**
• **SEKIBE, Tsutomu**
**Hirakata-shi, Osaka 573-0047 (JP)**

(74) Representative: **Dempster, Benjamin John Naftel et al**
**Withers & Rogers LLP**
**Goldings House,**
**2 Hays Lane**
**London SE1 2HW (GB)**

(56) References cited:
**US-A- 5 572 466          US-A- 5 603 001**

• **PATENT ABSTRACTS OF JAPAN vol. 2000, no. 07, 29 September 2000 (2000-09-29) & JP 2000 122917 A (SONY CORP), 28 April 2000 (2000-04-28)**
• **PATENT ABSTRACTS OF JAPAN vol. 2000, no. 08, 6 October 2000 (2000-10-06) & JP 2000 132982 A (SONY CORP), 12 May 2000 (2000-05-12) cited in the application**

**Description**

Field of The Invention

The present invention relates to a storing device to store data. More specifically, this invention concerns the storing device that stores data on storing mediums such as flash memory.

The Prior Art

In storing devices for portable devices handling music data or video data, it is common to use storing mediums like flash memory for the following reasons: 1) data can be rewritten, 2) the storing medium is quite portable, and 3) no backup with batteries or the like is needed.

However, the problem with the flash memory now in use is that a waiting time is needed when data is rewritten. The reason for that is this. It takes much longer to write the data transferred to the buffer on the flash memory than to transfer data, an object to be written, to the buffer within the storing device.

An attempt to solve the problem is unexamined Japanese patent application No. 2000 - 132982 that discloses a storing device provided with a plurality of flash memories. This storing device presents no waiting time problem because data can be written on a plurality of flash memories in parallel.

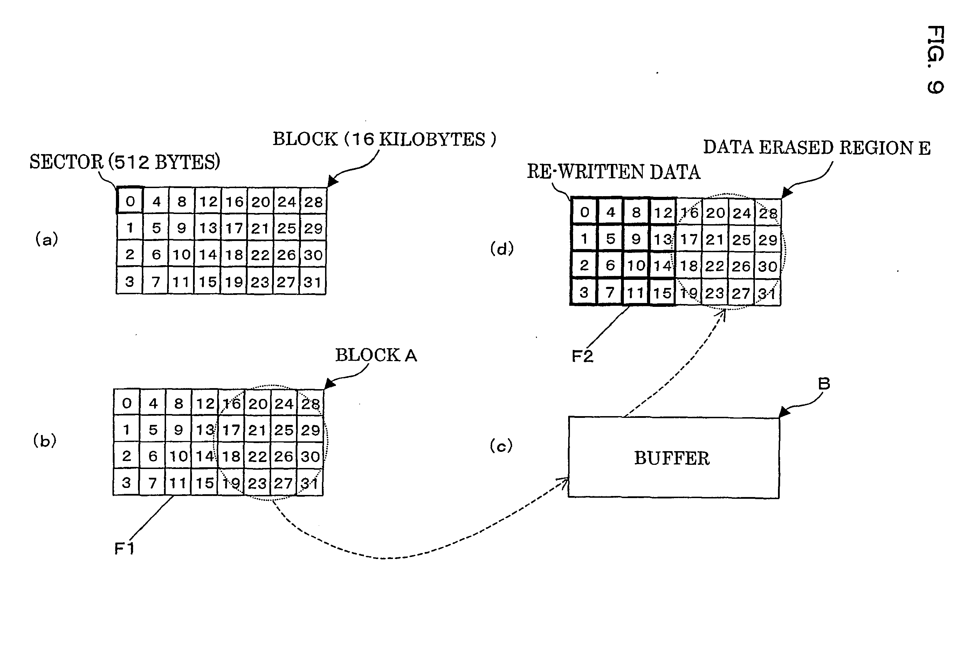

Generally, the unit or a quantity used as standard in which data are written on the flash memory is called sector, and the unit in which data on the flash memory are erased (which will be described later) is named block. That is, as shown in FIG. 9 (a), data within the flash memory, are managed block by block, each block made up of 32 sectors (it is to be understood that the data length of the sector is 512 bytes, and the data length of the block is 16 kilobytes).

The feature of the flash memory is that only one-way data rewriting is possible. In other words, it is impossible to rewrite the value of data from 1 to 0 (or from 0 to 1). Before data are written, therefore, it is necessary to change all the values of data at the writing destination to 1 (or 0). (Hereinafter, this changing is to be called "erasing." A region where this erasing is completed is to be called the "erased region" while a region where erasing is not completed is to be called the "unerased region.")

Such being the circumstances, when data 0 - 15 within block A shown in FIG. 9 (b) are to be rewritten, data 16 - 31 which do not have to be rewritten are first read out on buffer B from flash memory F1 as shown in FIG. 9 (c). Then, the data 16 - 31 thus read out on buffer B are rewritten on an erased region E of another flash memory F2, and then the data region of block A is erased.

The series of steps (that is, the steps to be taken so that the data 16 to 31 which do not have to be rewritten may not be involved in rewriting) is called evacuation of data, and is a major cause to reduce the speed of writing data in the flash memory. After rewriting shown in FIG. 9 (d), data 0 to 15 are transferred from outside to the storing device. About this step, no detailed description will be given.

In the storing device disclosed in unexamined Japanese patent application No. 2000 - 132982, data can be written on a plurality of flash memories in parallel, and there arises no waiting time problem. However, the problem is that if data are written on a plurality of flash memories in parallel, the frequency of evacuation in rewriting increases.

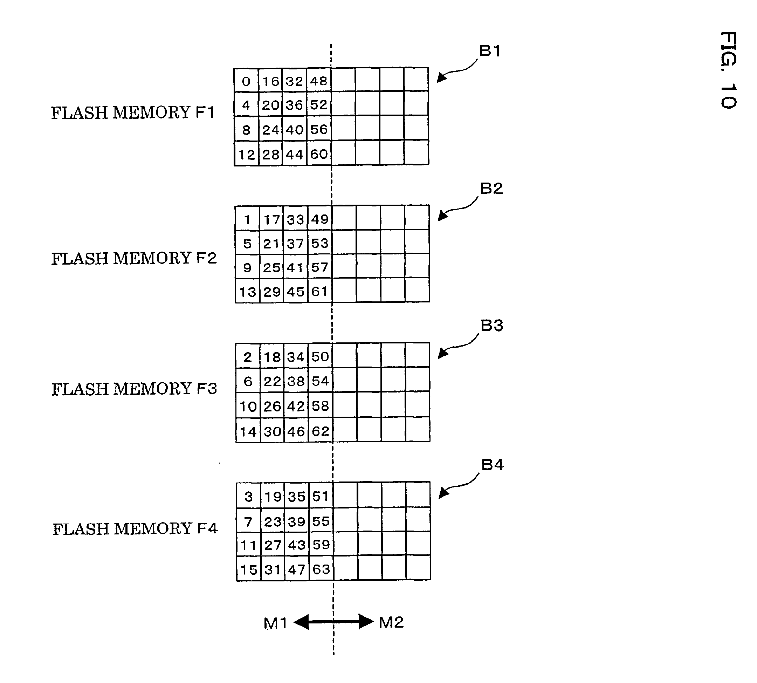

That is, if certain music data M1 is to be written on the flash memories, there will arise vacant regions in the last blocks (which is explained later) B1 to B4 of flash memories F1 to F4 as shown in FIG. 10 unless the data size is an integral multiple of (size of one block of the flash memory) x (number of flash memories). Then, if other music data M2 are written on the flash memories F1 to F4, the music data M2 will be written in vacant regions starting with the last blocks B1 to B4, and as a result, different music data M1, M2 will be present in the same blocks. Then, if the need arises to erase all the music data M1, it will be necessary to evacuate music data M2 written on the last blocks B1 to B4.

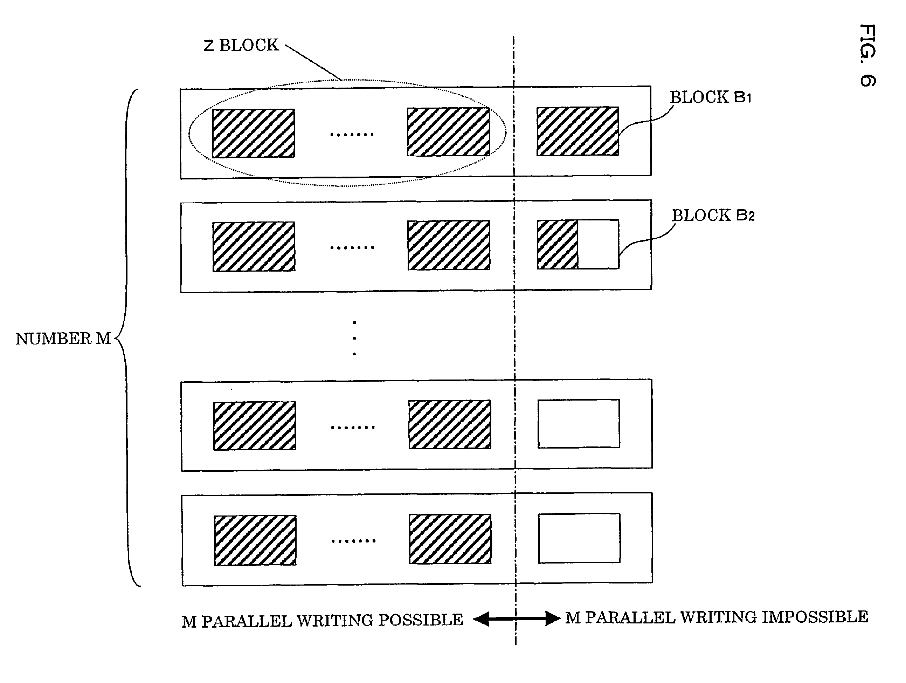

It is noted that the last block as mentioned above is a block in which data to be written is to be written last. That is, when data are written in m pieces of flash memories as shown in FIG.6, no vacant region occurs in the hatched blocks shown on the left side of the alternate long and short dash line but there is a possibility that a vacant region will occur in the hatched blocks on the right side of the alternate long and short dash line. The blocks where a vacant region can come out are blocks where data to be written is written last, and for this reason, these blocks shall be called "last blocks".

SUMMARY OF THE INVENTION

The present invention has been made in view of the above circumstances, and it is an object of the present invention to reduce the frequency with which the evacuation is needed in rewriting on the storing device which are written data on a plurality of flash memories in parallel.

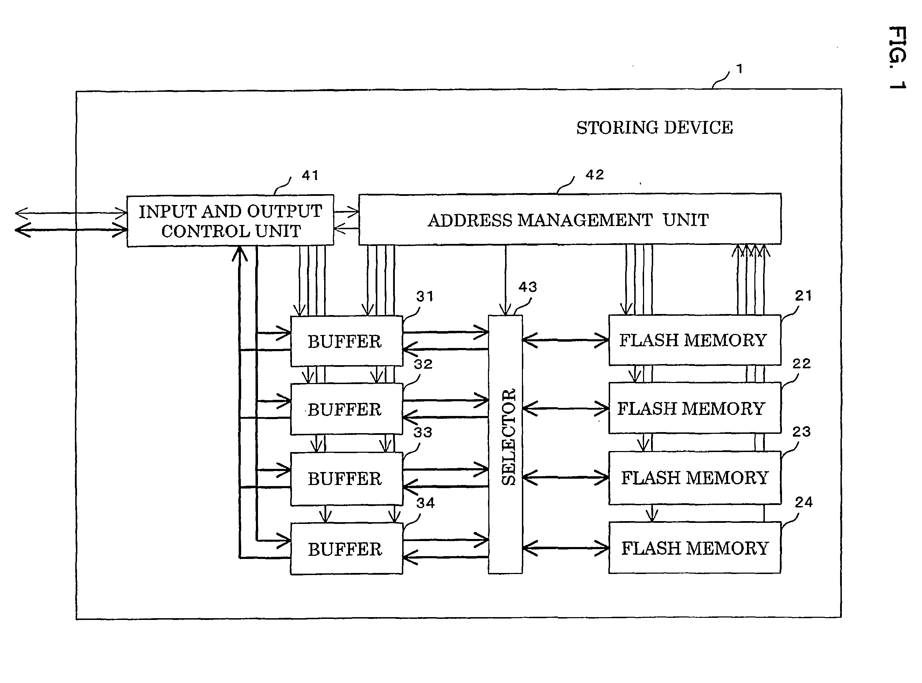

To achieve the foregoing object, the present invention adopts the following means. That is, the present invention is based on a storing device that, as shown in FIG. 1, writes data to the storing regions where erasing has been completed and writes data in parallel, the data of which the writing is requested from outside, on a plurality of storing mediums 21, 22, 23, 24 where data are erased on a block-by-block basis by the lump, each block made up of a plurality of storing regions.

With the size of all the data, the writing of which is requested from outside, indicated as q, the number of the storing mediums as m and the size of the block as p, address management unit 42 first divides size q of all the data, the writing of which is requested from outside, by size p of the block to obtain a quotient $zm + w + y$ ($z$ : 0

$\leq z$ (integer); $w : 0 \leq w < m$ (integer); $y : 0 \leq y < 1$). Address management unit 42 then so controls the data transfer as to write data for zm blocks on m pieces of storing mediums in parallel, and then write data for $(\frac{q}{p} \cdot zm)$ data on $w + 1$($w$ in the case of $y = 0$) pieces of storing mediums.

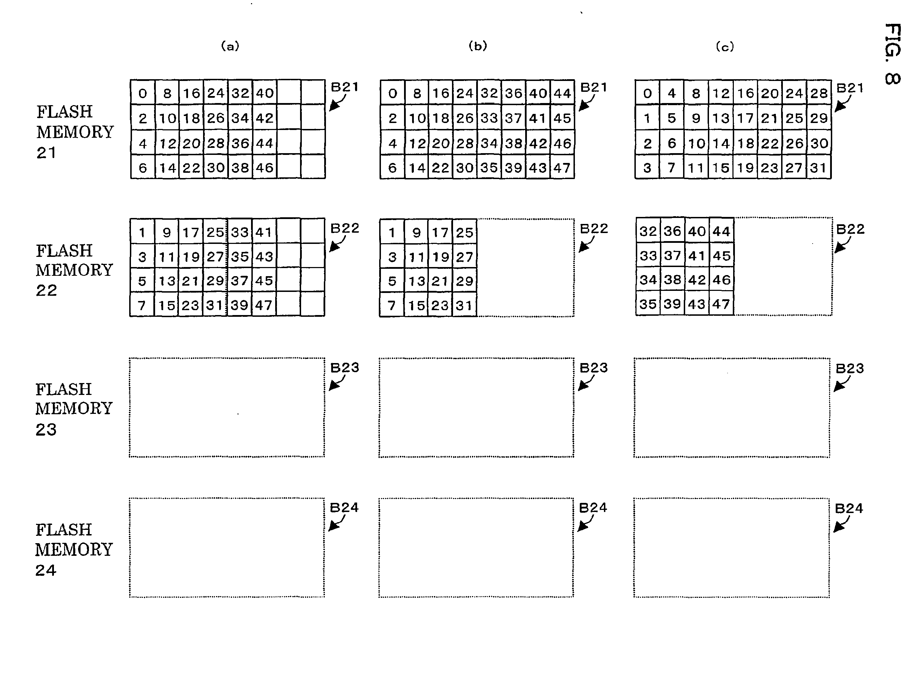

For example, address management unit 42 so controls the data transfer as to write the data for $(\frac{q}{p} \cdot zm)$ blocks on $w + 1$ pieces of storing mediums in parallel as shown in FIG. 8 (a). That reduces the number of blocks where vacant region is caused as compared with the prior art technique. Needless to say, that decreases the frequency with which evacuation in rewriting is needed.

As shown in FIG. 8 (b), of course, the data transfer may be so controlled that when the data for $(\frac{q}{p} \cdot zm)$ blocks are written, the processing for writing data for y blocks on one piece of storing medium is performed on $w + 1$ pieces of storing mediums in parallel, and after that, the processing for writing data for $(1 - y)$ blocks on one piece of storing medium is performed on w pieces of storing mediums in parallel. That brings to one at most the number of blocks where is caused, and therefore the frequency with which the evacuation in rewriting is needed will further decrease.

Or, the data transfer may be so controlled to allocate the data for $(\frac{q}{p} \cdot zm)$ blocks to $w + 1$ pieces of storing mediums and to write on the respective storing mediums in a specific order as shown in FIG. 8 (c). This control method is effective especially when there exist "data that do not need to be rewritten" on the blocks to which the storing region, that is, requested writing destination belongs. That is, in such a case, address management unit 42 controls the data transfer by regarding the sum of the data not necessary to rewrite and the data, of which the writing is requested, as data for (q - zm) blocks.

BRIEF DESCRIPTION OF THE DRAWINGS

FIG. 1 is a block diagram of a storing device to which the present invention is applied.
FIG. 2 is an explanatory diagram of the first data writing control method.
FIG. 3 is a block control table at the time of the first data writing control.

FIG. 4 is an explanatory diagram of the second data writing control method.
FIG. 5 is a block management table at the time of the second data writing control.
FIG. 6 is an explanatory diagram of a technique judging the data writing control method.
FIG. 7 is diagram of data rewriting.
FIG. 8 is a diagram in which data for (q - zm) blocks are being rewritten.
FIG. 9 is an explanatory diagram of a block, sector and evacuation in rewriting.
FIG. 10 is an explanatory diagram of blocks in which other data exist.

DESCRIPTION OF THE PREFERRED EMBODIMENTS

FIG. 1 is a block diagram of a storing device to which the present invention is applied, and its configuration will be described. In the following description, it is presupposed that the data length of the sector is 512 bytes and the data length of the block is 16 kilobytes.

First, receiving a request for writing, reading, erasing data or the like from outside, input and output control unit 41 issues instructions for starting the processing of the request to address management unit 41 and controls the inputting and outputting of data as follows.

That is, receiving a request for writing data, input and output control unit 41 writes data inputted from outside on a plurality of buffers 31, 32, 33, 34 in 512 bytes one after another. On the other hand, receiving a request for reading out data, input and output control unit 41 reads out data in 512 bytes from a plurality of buffers 31, 32, 33, 34 and output them in 512 bytes to outside one after another.

In compliance with a processing starting instruction from input and output control unit 41, address management unit 42 controls transfer of data between a plurality of flash memories 21, 22, 23, 24 and a plurality of buffers 31, 32, 33, 34, controls the erasing of data on a plurality of flash memories 21, 22, 23, 24, and manages data written on a plurality of flash memories 21, 22, 23, 24 (which will be described in detail later).

Furthermore, according to a connection switchover signal from address management unit 42, selector 43 switches connection of data buses between a plurality of flash memories 21, 22, 23, 24 and a plurality of buffers 31, 32, 33, 34.

There are two methods of controlling the writing of data by the address management unit 42. One is a control method used when a request is received to write data on a logical address region where no data have been written yet (hereinafter referred to as "first data writing control method") and the other is a control method used when a request is received to write data in a logical address region where data have already been written (hereinafter referred to as "second data writing control method").

Now, those data writing control methods will be described in detail.

[First data writing control method]

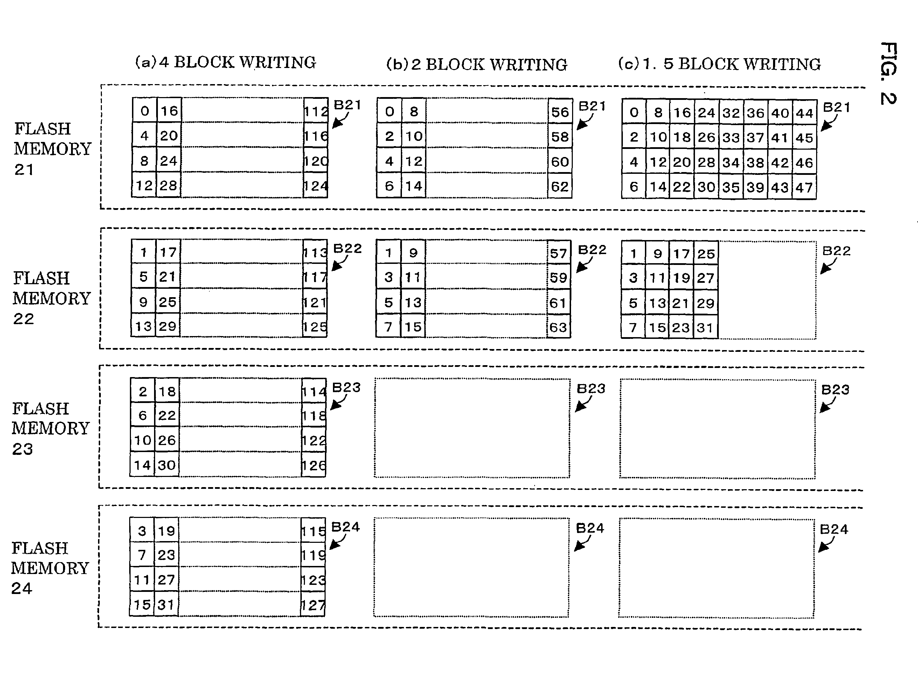

First, receiving a request to write data in a logical address region where no data have been written, data are written in 4 flash memories 21, 22, 23, 24 in parallel as in the prior art. In the present invention, however, the way of controlling writing data in the respective last blocks of flash memories 21, 22, 23, 24 as shown in FIG. 2 (a) to (c) is different depending on the size of data, an object to be written.

In case the size of data, an object to be written, is 64 kilobytes, for example, even if the data are written on 4 flash memories 21, 22, 23, 24 in parallel, any of the last blocks B21, B22, B23, B24 will not have vacant regions. That is because data of 64 kilobytes corresponds to 4 blocks and is identical with the sum of the last blocks B21, B22, B23, B24.

Therefore, address management unit 42 in this case so controls the data transfer that data 0 to 127 will be written on the last blocks B21, B22, B23, B24 in parallel as shown in FIG. 2 (a) (hereinafter this mode of writing is to be called "4-block writing").

In case the size of data, an object to be written, is 32 kilobytes, if this data is written in 4 flash memories 21, 22, 23, 24, 1/2 region of each of the last blocks B21, B22, B23, B24 will be vacant. That is because data of 32 kilobytes corresponds to two blocks and is equal to 1/2 of the sum of the lasts block B21, B22, B23, B24.

Therefore, address management unit 42 in this case so controls the data transfer that data 0 to 63 are written on only two last blocks B21, B22. That is, to prevent blocks from having vacant regions, address management unit 42 so controls the data transfer that the parallelism degree is limited to from 4 to 2 for writing on the last block B21, B22, B23, B24 (hereinafter this mode of writing is called "two-block writing."

Here, if the size of data, an object to be written, is 24 kilobytes, it will be impossible to prevent the last blocks from having vacant regions even if the parallelism degree is limited as in the case of the data size being 32 kilobytes. That is because the 24-kilobyte data corresponds to 1.5 blocks and is not equal to an integral multiple of the block.

Therefore, address management unit 42 in this case so controls the data transfer that the last one block alone will have vacant region (see block B22) as shown in FIG. 2 (c) and so controls data 0 to 47 that data are written in parallel as far as possible.

In other words, after data 0 to 31 for one block are written on two last blocks B21, B22 in parallel, fractional data 32 to 47 for the remaining 0.5 block is written on the last block B21 singly (hereinafter this mode of writing is to be called "1.5 block writing."). The expression "to write singly" used herein means to write in parallel with a parallelism degree of 1.

As set forth above, address management unit 42 selects one of the control methods depending on the size of data, an object to be written. There will be described the selecting technique.

First, with the size of all the data of which the writing is requested as q, the number of flash memories as m, the size of block as p, the size q of the all the data is divided by the block size p to obtain a quotient zm + w + y (z : $0 \leq z$ (integer); w : $0 \leq w$ (integer) < m; y : $0 \leq y < 1$).

In the formula, zm is the number of blocks with a parallelism degree of m, and the formula w + y means the number of blocks where the parallelism degree does not reach m. That is, referring to FIG. 6, the number of the hatched blocks on the left side of alternate long and short dash line corresponds to zm, while the number of the hatched blocks on the left side of the alternate long and short dash line corresponds to w + y (w corresponds to block $B_1$, while y corresponds to the block $B_2$.)

Therefore, address management unit 42 controls the data transfer so that data for zm blocks are written on m pieces of flash memories in parallel and after that, data for $(\frac{q}{p} - zm)$ blocks are written on w + 1 pieces (in the case of y = 0, w) of flash memories. But when data for $(\frac{q}{p} - zm)$ blocks are written, the processing for the writing of data for y blocks in one flash memory is performed on w + 1 pieces of flash memories in parallel, and after that, the processing for the writing of data for (1 - y) blocks in one flash memory is performed on w pieces of flash memories in parallel.

As a concrete example of the selecting technique, a control procedure will be explained in which one block is 16 kilobytes and 152 kilobytes of data are written on 4 flash memories (p = 16, m = 4, q = 152).

First, because q ÷ p = zm + w + y is 152 ÷ 16 = 2 x 4 + 1 + 0.5, it is found that z is 2; w is 1; y is 0.5.

Therefore, data for two blocks are written on 4 pieces of flash memories in parallel, and after that, data for 1.5 blocks are written on 2 pieces of flash memories. But when data for 1.5 blocks are written, the processing for the writing of data for 0.5 block on one flash memory is carried out on two pieces of flash memories, and after that, the processing for the writing of data for (1 - 0.5) block on one piece of flash memory is carried out on one piece of flash memory in parallel. That is, referring to FIG. 6, data for 0.5 block is written on block $B_1$ and block $B_2$ respectively, and after that, data for 0.5 block is written only on block $B_1$ singly.

It has been described that the size p of all the data, the writing of which is requested, is 152 kilobytes and the size q of block is 16 kilobytes. The unit of the size p and size q is not limited to byte. Even if, for example, the size p of all the data, the writing of which is requested, is 304 sectors and the size q of the block is 32 sectors, the same results can be obtained.

According to the present invention, as set forth above, the number of blocks that have vacant region is at most one. That reduces the frequency with which evacuation in rewriting will decrease. As a whole, it is possible to improve the performance of writing in flash memories.

But according to the present invention, the parallelism degree is sometimes limited, and that reduces the writing speed. However, the parallelism is limited only with the last blocks, and with the last blocks, too, writing is carried out in parallel as far as possible. Even if the parallelism is limited as described above, therefore, its effect on the writing speed is very small.

In the above description, the procedure for writing in parallel in flash memories in this order, flash memories $21 \rightarrow 22 \rightarrow 23 \rightarrow 24 \rightarrow 21 \rightarrow ...$, is explained but the present invention is limited to that. That is, the respective flash memories are varied in hardware performance, and the time required for each writing is not the same. Therefore, it is desirable that the data transfer is so controlled that data are written one after another in flash memories as these flash memories are ready for writing instead of parallel writing as described above.

In the above description, the "ready for writing" means as follows: if a specific data is being written into a specific sector of a specific block, the specific sector of the specific block is forbidden to writing a next new data therein. The writing into this specific sector should be effective after the completion of writing the specific data into the specific sector. Therefore, the "ready for writing" means the status after the completion of writing the prior data.

As shown in FIG. 2 (b), (c), if the size of data, an object to write, is 32 kilobytes or 24 kilobytes, there is a period when the parallelism degree is limited to 2, that is, a period for parallel writing in two flash memories 21, 22. If, therefore, there exists an unerased region within the remaining flash memories 23, 24, it is desirable to carry out the erasing of this region along with writing in the flash memories 21, 22.

In the above description, furthermore, when data for $\left( \dfrac{q}{p} \cdot zm \right)$ blocks are written, the processing for the writing of data for y blocks on one piece of flash memory is carried out on w + 1 pieces of flash memories in parallel, and after that, the processing of writing data for (1 - y) blocks on one piece of flash memory is performed on w pieces of flash memories in parallel. But the present invention is not limited to that. That is, as shown in 8 (a), data for $\left( \dfrac{q}{p} \cdot zm \right)$ blocks may be written on w + 1 flash memories in parallel.

But in this case, there is a possibility that the number of blocks having vacant regions will two or more. Yet, needless to say, the number is smaller than when the prior art technique, having m blocs vacant regions, is used.

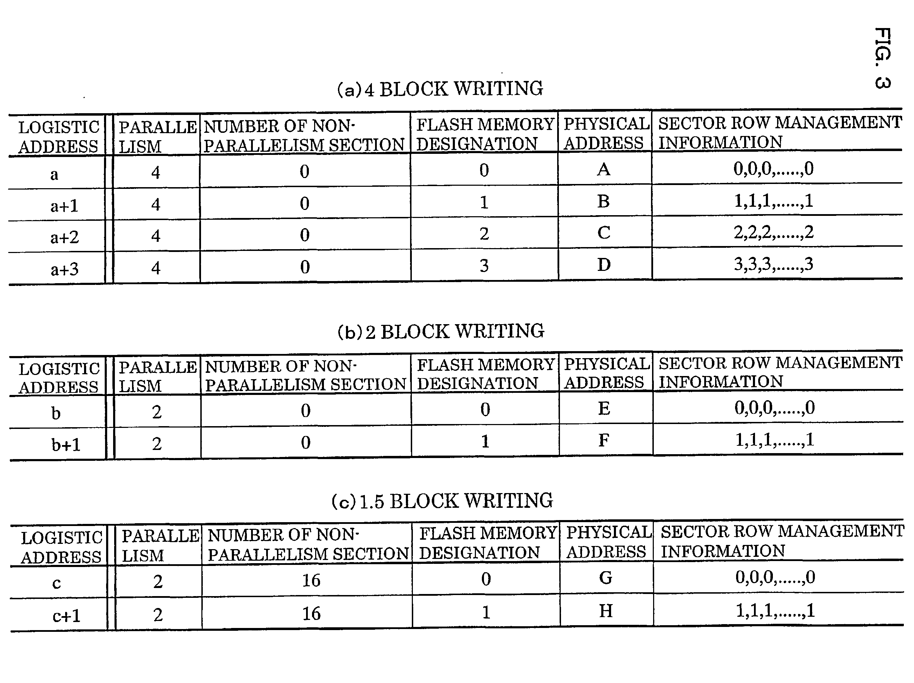

Meanwhile, to read or rewrite data written in parallel as described above, address management unit 42 has to control and manage the state of data writing in the flash memories 21, 22, 23, 24. That is, address management unit 42 is so arranged as to generate a block management table (see FIG. 3) provided with the following fields for every logical address block to which access is requested from outside.

The expression parallelism degree field is a field to show on how many flash memories data are written in parallel. That is, in the parallelism degree field of a logical address block in which 4 blocks are written as mentioned above, "4" is set as shown in FIG. 3 (a). Meanwhile, in the parallelism degree field of the logical address block where two blocks are written and 1.5 blocks are written, "2" is set as shown in FIG. 3 (b), (c). In the parallelism degree field for the logical address block where no blocks are written, "0" is set.

Next, the field for the number of non-parallelism sectors means a field showing, of 32 pieces of sectors contained in the logical address blocks, the number of sectors where parallelism writing is not carried out. That is, in the field for the number of non-parallelism sectors where four blocks and two blocks are written, "0" is set as shown in FIG. 3 (a), (b). Meanwhile, in the field for the number of non-parallelism sectors field where 1.5 blocks are written, "16" is set as shown in FIG. 3 (c).

Next, the flash memory designated field is a field to indicate a flash memory where the address block exists. For example, in the flash memory designated field of the logical address block which is present within the flash memory 21, "0" is set, and in the flash memory designated field of the logical address block which is present within the flash memory 22, "1" is set. In the flash memory designated field of the logical address block which is present within the flash memory 23, "2" is set, and in the flash memory designated field of the logical address block which is present within the flash memory 24, "3" is set

Next, the physical address field is a field indicating the physical address corresponding to the logical address block. Needless to say, the physical address set in that field is a physical address within the flash memory indicated in the flash memory designated field.

Next, the sector row control field is a field indicating the parallel writing order in sectors. For example, if parallel writing is done in this order: flash memories $21 \rightarrow 22 \rightarrow 23 \rightarrow 24 \rightarrow 21 \rightarrow ...$, "0" as sector row control information corresponding to logical address a, "1" as sector row control information corresponding to logical address a +1, "2" as sector row control information corresponding to logical address a + 2, "3" as sector row control information corresponding to logical address a + 3 rank as shown in FIG. 3 (a).

[Second data writing control method]

Meanwhile, data to be written on the flash memory are usually a series of image data or music data (one image film or one music file). Even when data written on the flash memory are erased, there is a possibility that a series of image data or music data (that is, data continuously written) will be erased by the lump. In the first data writing control, therefore, data are written in parallel in principle as far as possible so as not to reduce the writing speed.

However, rather than writing in parallel as far as possible as the first data writing control method, single writing sometimes improves performance of writing data in the flash memory in some cases if viewed as a whole.

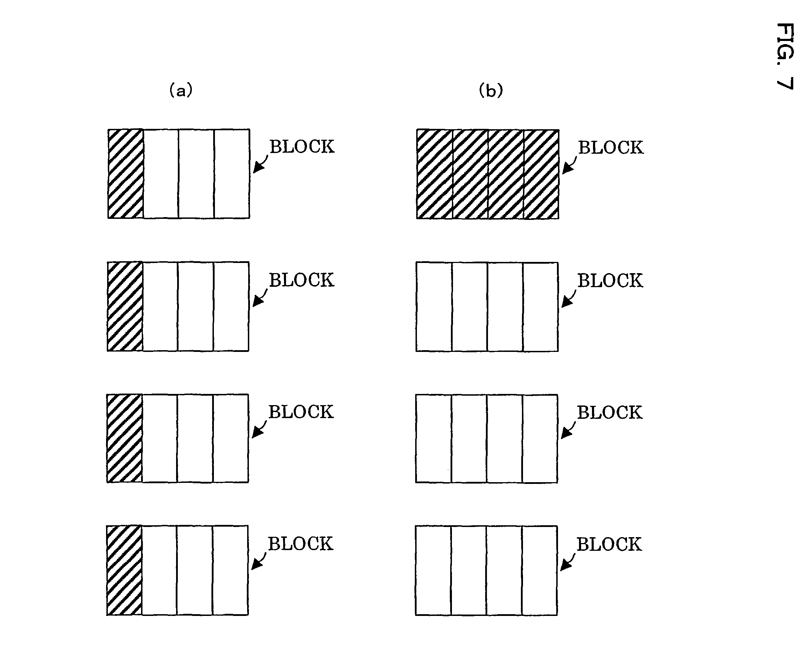

In editing work on music data written on the flash memory, for example, part of the continuously written data needs to be rewritten. In this case, it is better that the data, an object to be rewritten, is written on one block as hatched area as shown in FIG. 7 (b) rather than being written over a plurality of blocks shown as hatched regions. That is because in the case shown in FIG. 7 (a) (prior art), four blocks have to be evacuated in rewriting while in the case shown in FIG. 7 (b), one block has to be evaluated in rewriting.

For such a reason, if after continuous data are written in a plurality of flash memories in parallel by the first data writing control method, part of this continuous data should have to be written, it is preferable to adopt the following control method.

Receiving a request to write data, address management unit 42 refers to the contents of the block control table and judges whether the request to write data is a request to rewrite part of the continuous data (hereinafter referred as "request to rewrite data ") or a request to newly continuous data (hereinafter referred to as "request to write new data." In other words, in the case of a request to write data in a logical address region where data have already been written, this request to write data is judged as request to rewrite data, while in the case of a request to write data in a logical address region where no data have been written yet, the request to write data is judged as a request to write new data.

And judging that the request to write data is a request to write new data, address management unit 42 adopts the first data writing control method. On the other hand, address management unit 42, which judges the request to write data as a request to rewrite data, further judges if there is data that does not have to be rewritten in the block to which the data, an object to write, belongs.

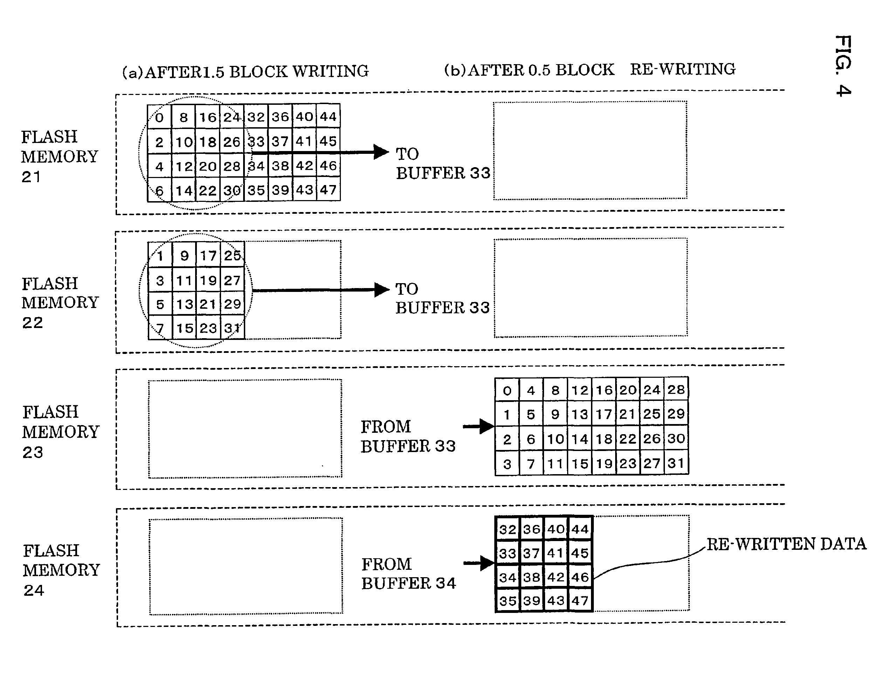

As shown in FIG. 4, for example, when data 0 to 47 are written in flash memories 21, 22 in the 1.5 block writing method and there is a request to rewrite data 32 to 47, there are data 0 to 31 (except for odd number) that do not have to be rewritten in the blocks to which data 32 to 47 belong. Therefore, in this case, address management unit 42 judges that "there are data that do not have to be rewritten, and exercises the following controls.

First, address management unit 42 takes data for 1.5 block as data for (q - zm) blocks, the data for 1.5 block being the sum of data 0 - 31 (32 pieces of sector data) that do not have to be re-written and data 32 to 47 (16 pieces of sector data, the writing of which is requested. Here, needless to say, w is 1 and y is 0.5.

And address management unit 42 controls the data transfer so that while data for $(\dfrac{q}{p} - zm)$ blocks are allocated to w + 1 pieces of flash memory 23, 24, the respective flash memories 23, 24 are written in a specific order (in this case, 23 → 24). That is, the data transfer is so controlled that data 0 - 31 written in two pieces of blocks in parallel are first read out on the buffer and then rewritten singly on an erased region of flash memory 23, then data 32 to 47 are written singly in the erased region of the flash memory 24. It is noted that the data 32 to 47 are referred to address management unit 42 from outside through input and output control unit 41, buffer 34.

According to the second data writing control as mentioned above, in the blocks on flash memories 23, 24, continuous data rank as far as possible. Under this arrangement, if there arise a need to rewrite data 0 to 31 or data 32 to 47, no evacuation in rewriting will occur.

There has been described the operation if address management unit 42 judges that "there exist data that do not have to be rewritten." That is, no mention is made of the operation when address management unit 42 judges that "there are no data that do not have to be re-written." In such a judgement, arrangements are so made that address management unit 42 adopts the first data writing control method.

That is because that "there are not data that do not have to be rewritten" means that all data will be re-written. For example, that there is a request to write data for two blocks in the 1.5 block region means that data for the previous 1.5 blocks is not needed. Therefore, it is reasonable that such a request to write data is considered to be a request to newly write continuous data.

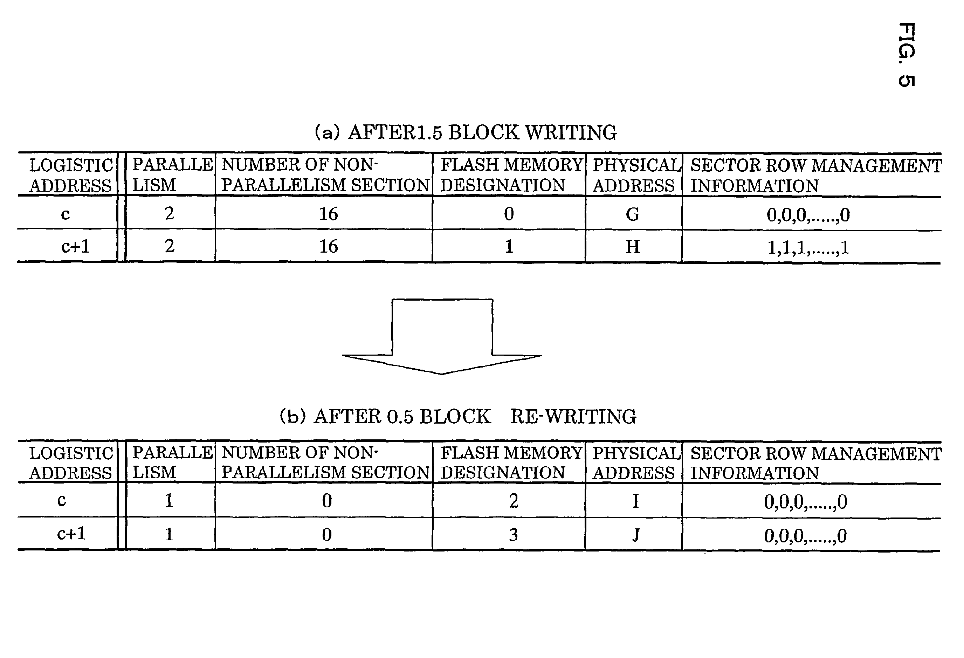

Finally, how the contents of the block control table undergoes changes by an example of the second data writing control is shown in FIG. 5. The arrangements of fields and setting information are the same as the first data writing control and will not be described.

**Claims**

1. A storing device wherein data are written in a storing region where erasing is completed, and data, the writing of which is requested from outside, are written on a plurality of storing mediums in parallel where data are erased block by block by the lump, each block being made up of a plurality of storing regions, said device comprising;

   an address management unit so controlling the data transfer that when with the size of all the data, the writing of which is requested from outside, as q, the number of said storing mediums as m and the size of said block as p, the size q is divided by the size p to obtain a quotient zm + w + y (z : 0 ≤ z (integer); w : 0 ≤ w (integer) < m; y : 0 ≤ y < 1), data for zm blocks are written on the storing mediums in parallel and after that, data for $(\frac{q}{p} - zm)$ blocks are written on w + 1 (w in the case of y = 0) pieces of storing mediums.

2. The storing device of claim 1 wherein said address management unit so controls the data transfer that said data for $(\frac{q}{p} - zm)$ blocks are written on w + 1 pieces of storing mediums in parallel.

3. The storing device of claim 1 wherein said address management unit so controls the data transfer that when said data for $(\frac{q}{p} - zm)$ blocks are written, the processing for writing data for y blocks on one storing medium is performed on w + 1 pieces of storing mediums in parallel and after that, the processing for writing data for (1 - y) blocks on one storing medium is performed on w pieces of storing mediums in parallel.

4. The storing device of claim 1 wherein said address management control so controls the data transfer that said data for $(\frac{q}{p} - zm)$ blocks are allocated to w + 1 pieces of storing mediums and written in a specific order assigned to each storing medium.

5. The storing device of claim 4 wherein when there exist data that do not need to be rewritten within a block to which the storing region, a writing destination, belongs, said address management unit so controls the data transfer by regarding the sum of data that does not need to be rewritten and the data, the writing of which is requested, as said data for $(\frac{q}{p} - zm)$ blocks:

6. The storing device of claim 1 wherein said address management unit so controls the data transfer that data are written one after another in storing mediums as said storing mediums are ready for writing.

7. The storing device of claim 1 wherein when blocks where data have not been erased exist on a storing medium which is not a writing destination, said address management unit erases data from the block and write data at the same time.

8. The storing device of claim 1 wherein said address management unit has a management table on which information can be set related to a logical address to which access is requested from outside, said information being at least one of the following kinds of information: storing medium designation information to specify a storing medium, physical address information to indicate a physical address of the storing medium where data are written, parallelism degree information to indicate whether data are written on a number of storing mediums in parallel, non-parallelism storing region information to indicate the number of storing regions where data are not written in parallel and storing region row management information to indicate parallel writing order by storing region by storing region.

9. A storing control method wherein data are written in storing regions wherein erasing has been completed, and data, the writing of which is requested from outside, are written in parallel on a plurality of storing regions where data are erased block by block by the lump, each block being made up of a plurality of storing regions, said storing control method so control the data transfer that when with the size of all the data, the writing of which is requested from outside, as q, the number of said storing mediums as m and the size of said block as p, the size q of all the data, the writing of which is requested from outside, is divided by the size p of said block to obtain a quotient zm + w + y (z : 0 ≤ z (integer); w : 0 ≤ w (integer) < m; y : 0 ≤ y < 1), data for zm blocks are written on the storing mediums in parallel and after that, data for $(\frac{q}{p} - zm)$ blocks are written on w + 1 (in the case of y = 0, w) pieces of storing mediums.

10. A program to have a storing device execute the address management control processing, said storing device wherein data are written on a storing region where erasing has been completed, and data, the writing of which is requested from outside, are written on a plurality of storing mediums where data are erased on block by block by the lump, each block being made up of a plurality of storing regions, and wherein when with the size of all the data, the writing of which is requested from outside, as q, the number of said storing mediums as m and the size of said block as p, the size q of all the data, the writing of which is requested from outside, is divided by the size p of said block to obtain a quotient zm + w + y (z : 0 ≤ z (integer); w : 0 ≤ w (integer) < m; y : 0 ≤ y < 1), data for zm blocks are written on the storing mediums in parallel and after that, data for $(\frac{q}{p} - zm)$ blocks are written on w + 1(w in the case of y = 0) pieces of storing mediums.

11. The program of claim 10 which so controls the data transfer that said data for $(\frac{q}{p} - zm)$ blocks are written on w + 1 pieces of storing mediums in parallel.

12. The program of claim 10 which so controls the data transfer that when said data for $(\frac{q}{p} - zm)$ blocks are written, the processing for writing data for y blocks on one piece storing medium is performed on w + 1 pieces of storing mediums and after that, the processing for writing data for (1 - y) blocks on one piece of storing medium is performed on w pieces of storing mediums in parallel.

13. The program of claim 10 which so controls the data transfer that said data for $(\frac{q}{p} - zm)$ blocks are allocated to w + 1 pieces of storing mediums, and data are written in a specific order.

14. The program of claim 13 which so controls the data transfer that when there are data that do need to be rewritten within the block to which the storing region, a requested writing designation, belongs, the sum of data that do not need to be written and data, the writing of which is requested, is regarded as said data for $(\frac{q}{p} - zm)$ blocks.

**Patentansprüche**

1. Speichervorrichtung, bei welcher Daten in einen Speicherbereich geschrieben werden, der vollständig gelöscht ist, und Daten, deren Einschreiben von außerhalb gefordert wird, in einer Mehrzahl von Speichermedien parallel eingeschrieben werden, wo Daten Block für Block durch das "Lump" gelöscht worden sind, wobei jeder Block aus einer Mehrzahl von Speicherbereichen besteht, mit
einer Adressenmanagementeinheit, welche den Datentransfer so steuert, dass dann, wenn die Größe aller Daten, deren Einschreiben von außerhalb gefordert wird q ist, die Anzahl der Speichermedien m ist und die Größe des Blockes p ist, die Größe q durch die Größe p geteilt wird, um einen Quotienten zm + w + y (z : 0 ≤ z (ganze Zahl) zu erhalten; w : 0 ≤ w (ganze Zahl) < m; y : 0 ≤ y < 1), Daten für zm Blocks in die Speichermedien parallel eingeschrieben werden und danach Daten für (q/p - zm) Blocks in w + 1 (w im Falle von y = 0) Exemplaren von Speichermedien geschrieben werden.

2. Speichervorrichtung nach Anspruch 1, bei welcher die Adressenmanagementeinheit den Datentransfer so steuert, dass die Daten für (q/p - zm) Blocks in w + 1 Exemplar von Speichermedien parallel eingeschrieben werden.

3. Speichervorrichtung nach Anspruch 1, bei welcher die Adressenmanagementeinheit den Datentransfer so steuert, dass dann, wenn Daten für (q/p - zm) Blocks eingeschrieben werden, der Vorgang des Datenschreibens für y Blocks in einem Speichermedium auf w + 1 Exemplaren von Speichermedien parallel erfolgt und danach der Vorgang des Datenschreibens für (1 - y) Blocks in einem Speichermedium in w Exemplaren von Speichermedien parallel erfolgt.

4. Speichervorrichtung nach Anspruch 1, bei welcher die Adressenmanagementsteuerung so erfolgt, dass der Datentransfer der Daten für (q/p - zm) Blocks w + 1 Exemplaren von Speichermedien zugeordnet werden und in einer jedem Speichermedium zugeordneten speziellen Reihenfolge eingeschrieben werden.

5. Speichervorrichtung nach Anspruch 1, bei welcher dann, wenn Daten vorhanden sind, die nicht in einen Block neu eingeschrieben werden müssen, zu welchem der Speicherbereich und ein Schreibbestimmungsort gehören, die Adressenmanagementeinheit den Datentransfer steuert unter Berücksichtigung der Summe von Daten, die nicht neu geschrieben werden müssen, und der Daten, deren Schreiben gefordert wird, wie die Daten für (q/p - zm) Blocks.

6. Speichervorrichtung nach Anspruch 1, bei welcher die Adressenmanagementeinheit den Datentransfer so steuert, dass Daten nacheinander in Speichermedien, wie die schreibbereiten Speichermedien, eingeschrieben werden.

7. Speichervorrichtung nach Anspruch 1, bei welcher dann, wenn Blocks, wo keine Daten gelöscht worden sind, in einem Speichermedium vorhanden sind, das keinen Schreibbestimmungsort darstellt, die Adressenmanagementeinheit Daten von dem Block löscht und gleichzeitig Daten einschreibt.

8. Speichervorrichtung nach Anspruch 1, bei welcher die Adressenmanagementeinheit eine Managementtabelle aufweist, in welche Information eingesetzt werden kann, die in Beziehung zu einer logischen Adresse steht, zu welcher Zugriff von außen gefordert wird, wobei die Information mindestens eine der folgenden Informationsarten ist: Speichermediumbestimmungsinformation zur Bezeichnung eines Speichermediums, physische Adresseninformation zur Angabe einer physischen Adresse des Speichermediums, wo die Daten hingeschrieben werden sollen, Parallelismusgradinformation zur Angabe, ob Daten in eine Anzahl von Speichermedium parallel eingeschrieben werden, Nichtparallelismusspeicherbereichsinformation zu Angabe der Anzahl von Speicherbereichen, wo Daten nicht parallel eingeschrieben werden, und Speicherbereichsreihenmanagementinformation zur Angabe der Paralleleinschreibreihenfolge Speicherbereich für Speicherbereich.

9. Speichersteuerverfahren, bei welchem Daten in Speicherbereiche geschrieben werden, die vollständig gelöscht sind, und Daten, deren Einschreiben von außerhalb gefordert wird, parallel in eine Mehrzahl von Speicherbereiche geschrieben werden, wo Daten Block für Block durch das "Lump" gelöscht worden sind, wobei jeder Block aus einer Mehrzahl von Speicherbereichen besteht, wobei das Speichersteuerverfahren den Datentransfer so steuert, dass dann, wenn die Größe aller Daten, deren Einschreiben von außerhalb gefordert wird, q ist, die Anzahl der Speichermedien m ist und die Größe des Blocks p ist, die Größe q aller Daten, deren Schreiben von außerhalb gefordert wird, durch die Größe p des Blockes geteilt wird, um den Quotient zu erhalten $zm + w + y$ ($z : 0 \le z$ (ganze Zahl); $w : 0 \le w$ (ganze Zahl) $< m$; $y : 0 \le y \le 1$) Daten für $zm$ Blocks in die Speichermedien parallel eingeschrieben werden und danach Daten für ($q/p - zm$) Blocks in $w + 1$ (im Fall von $y = 0$, $w$) Exemplare von Speichermedien geschrieben werden.

10. Programm für eine Speichervorrichtung zur Durchführung des Adressenmanagementsteuervorgangs, wobei in die Speichervorrichtung Daten in einen Speicherbereich geschrieben werden, der vollständig gelöscht ist, und Daten, deren Einschreiben von außerhalb gefordert wird, in eine Mehrzahl von Speichermedien eingeschrieben werden, wo Daten Block für Block von dem "Lump" gelöscht worden sind, wobei jeder Block aus einer Mehrzahl von Speicherbereichen besteht und wobei dann, wenn die Größe aller Daten, deren Einschreiben von außerhalb erfordert wird, q ist, die Anzahl der Speichermedien m ist und die Größe des Blocks p ist, die Größe q aller Daten, deren Einschreiben von außerhalb gefordert wird, durch die Größe p des Blocks dividiert wird, um einen Quotienten zu erhalten $zm + w + y$ ($z : 0 \le z$ (ganze Zahl); $w : 0 \le w$ (ganze Zahl) $< m$; $y : 0 \le y < 1$), Daten von $zm$ Blocks in die Speichermedien parallel eingeschrieben werden und danach von ($q/p - zm$) Blocks in $w + 1$ ($w$ im Fall von $y = 0$) Stücke von Speichermedien eingeschrieben werden.

11. Programm nach Anspruch 10, welches den Datentransfer derart steuert, dass Daten von ($q/p - zm$) Blocks in $w + 1$ Exemplare von Speichermedien parallel eingeschrieben werden.

12. Programm nach Anspruch 10, welches den Datentransfer so steuert, dass dann, wenn Daten für ($q/p - zm$) Blocks eingeschrieben werden, der Vorgang des Schreibens von Daten für y Blocks in einem Stückspeichermedium durchgeführt wird in $w + 1$ Exemplaren von Speichermedien und danach der Vorgang des Dateneinschreibens für ($1 - y$) Blocks in einem Speichermediumexemplar parallel in $w$ Exemplaren von Speichermedien durchgeführt wird.

13. Programm nach Anspruch 10, welches den Datentransfer derart steuert, dass Daten von ($q/p - zm$) Blocks $w + 1$ Exemplaren von Speichermedien zugeordnet werden und Daten in einer spezifischen Reihenfolge eingeschrieben werden.

14. Programm nach Anspruch 13, welches den Datentransfer so steuert, dass dann, wenn es Daten gibt, die nicht innerhalb des Blocks neu eingeschrieben werden müssen, zu welchem der Speicherbereich, ein geforderter Schreibbestimmungsort, gehört, die Summe der Daten, die nicht eingeschrieben werden müssen, und der Daten, deren Schreiben gefordert wird, als die Daten für ($p/q - zm$) Blocks betrachtet werden

## Revendications

1. Dispositif de mémorisation, dans lequel les données sont écrites dans une zone de stockage où l'effacement est terminé, et les données, dont l'écriture est demandée depuis l'extérieur, sont écrites sur une pluralité de supports de mémorisation en parallèle où les données sont effacées bloc par bloc, chaque bloc étant constitué d'une pluralité de régions de stockage, ledit dispositif comprenant :

une unité de gestion d'adresses commandant le transfert de données de telle sorte que lorsque, avec la taille de toutes les données dont l'écriture est demandée depuis l'extérieur, telle que q, le nombre desdits supports de stockage, tel que m, et la taille dudit bloc, tel que p, la taille q est divisée par la taille p pour obtenir un quotient $zm + w + y$ ($z : 0 \le z$ (nombre entier) ; $w : 0 \le W$ (nombre entier) $< m$ ; $y . 0 \le y < 1$), les

données pour les blocs zm sont écrites sur les supports de mémorisation en parallèle et, après cela, les données pour les blocs (

sont écrites sur les parties w + 1 (w dans le cas de y = 0) des supports de mémorisation.

2. Dispositif de mémorisation selon la revendication 1, dans lequel ladite unité de gestion d'adresses commande le transfert de données de telle sorte que lesdites données pour les blocs ( $\frac{q}{p}$ - zm)

sont écrites sur les parties w + 1 des supports de mémorisation en parallèle.

3. Dispositif de mémorisation selon la revendication 1, dans lequel ladite unité de gestion d'adresses commande le transfert de données de telle sorte que lorsque lesdites données pour les blocs

( $\frac{q}{p}$ - zm) sont écrites, le traitement pour l'écriture des données pour les blocs y sur un support de mémorisation s'effectue sur les parties W + 1 des supports de mémorisation en parallèle, et après quoi le traitement pour écrire les données pour les blocs (1 - y) sur un support de mémorisation est effectué sur les parties w des supports de mémorisation en parallèle.

4. Dispositif de mémorisation selon la revendication 1, dans lequel ladite commande de gestion d'adresses commande le transfert de données de telle sorte que lesdites données pour les blocs ( $\frac{q}{p}$ - zm)

sont affectées aux parties w + 1 des supports de mémorisation et écrites dans un ordre spécifique affecté à chaque support de mémorisation.

5. Dispositif de stockage selon la revendication 4, dans lequel, lorsqu'il existe des données qui ne nécessitent pas d'être réécrites à l'intérieur d'un bloc auquel fait partie la région de stockage, une destination d'écriture, ladite unité de gestion d'adresses commande le transfert de données en tenant compte de la somme de données qui n'ont pas besoin d'être réécrites et les données, dont l'écriture est demandée, en tant que dites données pour les blocs

( $\frac{q}{p}$ - zm).

6. Dispositif de mémorisation selon la revendication 1, dans lequel ladite unité de gestion d'adresses commande le transfert de données, de telle sorte que les données sont écrites l'une après l'autre dans les supports de mémorisation à mesure que lesdits supports de mémorisation sont prêts pour l'écriture.

7. Dispositif de stockage selon la revendication 1, dans lequel, lorsque les blocs ou les données n'ont pas été effacés existent sur un support de mémorisation, qui n'est pas une destination d'écriture, ladite unité de gestion d'adresses efface les données du bloc et écrit les données en même temps.

8. Dispositif de mémorisation selon la revendication 1, dans lequel ladite unité de gestion d'adresses comporte un tableau de gestion sur lequel les informations peuvent être mises en rapport à une adresse logique à laquelle l'accès est demandé depuis l'extérieur, lesdites informations étant au moins l'un des types suivants d'information : information de désignation de support de mémorisation pour préciser un support de mémorisation, information d'adresse physique pour indiquer une adresse physique du support de mémorisation où sont écrites les données, information de degré de parallélisme pour indiquer si les données sont écrites sur un nombre de supports de mémorisation en parallèle, information de région de stockage de non-parallélisme pour indiquer le nombre de régions de mémorisation où les données ne sont pas écrites en parallèle et des informations de gestion de rangées de régions de mémorisation pour indiquer l'ordre d'écritures parallèles par région de mémorisation.

9. Procédé de commande de mémorisation, dans lequel les données sont écrites dans des régions de mémorisation, dans lesquelles l'effacement a été effectué, et les données, dont l'écriture est demandée depuis l'extérieur, sont écrites en parallèle sur une pluralité de régions de mémorisation où les données sont effacées bloc par bloc, chaque bloc étant constitué d'une pluralité de régions de mémorisation, ledit procédé de commande de mémorisation commandant le transfert de données de telle sorte que lorsqu'avec la taille de toutes les données dont l'écriture a été demandée depuis l'extérieur, en tant que lettre q, le nombre desdits supports de mémorisation en tant que m et la taille dudit bloc en tant que p, la taille q de toutes les données, dont l'écriture a été demandée depuis l'extérieur, est divisé par la taille p dudit bloc pour obtenir un quotient zm + w + y (z : 0 ≤ z (nombre entier) ; w : 0 ≤ w (nombre entier) < m ; y : 0 ≤ y < 1), les données pour les blocs zm sont écrites sur les supports de mémorisation en parallèle et, après quoi les données pour les blocs

sont écrites sur les parties w + 1 (dans le cas de y = 0, w) des supports de mémorisation.

**10.** Programme pour obtenir un dispositif de mémorisation qui exécute le traitement de commande de gestion d'adresses, ledit dispositif de mémorisation dans lequel sont écrites les données sur une région de mémorisation où l'effacement a été effectué, et les données, dont l'écriture est demandée depuis l'extérieur, sont écrites sur une pluralité de supports de mémorisation dans lesquels les données ont été effacées bloc par bloc, chaque bloc étant constitué d'une pluralité de régions de mémorisation, et dans lequel lorsqu'avec la taille de toutes les données, dont l'écriture est demandée depuis l'extérieur, en tant que q, le nombre desdits supports de mémorisation en tant que m et la taille dudit bloc en tant que p, la taille q de toutes les données, dont l'écriture est demandée depuis l'extérieur, est divisé par la taille p dudit bloc pour obtenir un quotient zm + w + y (z : $0 \leq z$ (nombre entier) ; w : $0 \leq w$ (nombre entier) < m ; y : $0 \leq y < 1$), les données pour les blocs zm sont écrites sur les supports de mémorisation en parallèle et, après quoi les données pour les blocs

$$(\frac{q}{p} - zm)$$ sont écrites sur les parties w + 1 (w dans le cas de y = 0) des supports de mémorisation.

**11.** Programme selon la revendication 10, qui commande le transfert de données de telle sorte que lesdites données pour les blocs $(\frac{q}{p} - zm)$ sont écrites

sur les parties w + 1 des supports de mémorisation en parallèle.

**12.** Programme selon la revendication 10, qui commande le transfert de données de telle sorte que lorsque lesdites données pour les blocs $(\frac{q}{p} - zm)$

sont écrites, le traitement pour l'écriture des données pour les blocs y sur un support de mémorisation d'une pièce est effectué sur les parties w + 1 des supports de mémorisation, et après quoi le traitement pour l'écriture des données pour les blocs (1 - y) sur une partie du support de mémorisation s'effectue sur les parties w des supports de mémorisation en parallèle.

**13.** Programme selon la revendication 10, qui commande le transfert de données de telle sorte que lesdites données pour les blocs $(\frac{q}{p} - zm)$ sont affec-

tées aux parties w + 1 des moyens de mémorisation, et les données sont écrites dans un ordre spécifique.

**14.** Programme selon la revendication 13, qui commande le transfert de données de telle sorte que lorsque l'on a des données qui n'ont pas besoin d'être réécrites à l'intérieur du bloc auquel fait partie la région de mémorisation, une désignation d'écriture demandée, la somme de données qui ne nécessitent pas d'être réécrites et les données dont l'écriture a été demandée, sont considérées comme étant lesdites données pour les blocs $(\frac{q}{p} - zm)$.

FIG. 1

FIG. 2

EP 1 330 715 B1

(a) 4 BLOCK WRITING    (b) 2 BLOCK WRITING    (c) 1. 5 BLOCK WRITING

FLASH MEMORY 21

FLASH MEMORY 22

FLASH MEMORY 23

FLASH MEMORY 24

FIG. 3

EP 1 330 715 B1

## (a) 4 BLOCK WRITING

| LOGISTIC ADDRESS | PARALLE LISM | NUMBER OF NON-PARALLELISM SECTION | FLASH MEMORY DESIGNATION | PHYSICAL ADDRESS | SECTOR ROW MANAGEMENT INFORMATION |
|---|---|---|---|---|---|
| a | 4 | 0 | 0 | A | 0,0,0,.....,0 |
| a+1 | 4 | 0 | 1 | B | 1,1,1,.....,1 |
| a+2 | 4 | 0 | 2 | C | 2,2,2,.....,2 |
| a+3 | 4 | 0 | 3 | D | 3,3,3,.....,3 |

## (b) 2 BLOCK WRITING

| LOGISTIC ADDRESS | PARALLE LISM | NUMBER OF NON-PARALLELISM SECTION | FLASH MEMORY DESIGNATION | PHYSICAL ADDRESS | SECTOR ROW MANAGEMENT INFORMATION |
|---|---|---|---|---|---|
| b | 2 | 0 | 0 | E | 0,0,0,.....,0 |
| b+1 | 2 | 0 | 1 | F | 1,1,1,.....,1 |

## (c) 1.5 BLOCK WRITING

| LOGISTIC ADDRESS | PARALLE LISM | NUMBER OF NON-PARALLELISM SECTION | FLASH MEMORY DESIGNATION | PHYSICAL ADDRESS | SECTOR ROW MANAGEMENT INFORMATION |
|---|---|---|---|---|---|
| c | 2 | 16 | 0 | G | 0,0,0,.....,0 |
| c+1 | 2 | 16 | 1 | H | 1,1,1,.....,1 |

# FIG. 4

(a) AFTER 1.5 BLOCK WRITING    (b) AFTER 0.5 BLOCK    RE-WRITING

RE-WRITTEN DATA

FLASH MEMORY 21

| 0 | 8 | 16 | 24 | 32 | 36 | 40 | 44 |
| 2 | 10 | 18 | 26 | 33 | 34 | 42 | 46 |
| 4 | 12 | 20 | 28 | 37 | 38 | 41 | 45 |
| 6 | 14 | 22 | 30 | 35 | 39 | 43 | 47 |

TO BUFFER 33

FLASH MEMORY 22

| 1 | 9 | 17 | 25 |
| 3 | 11 | 19 | 27 |
| 5 | 13 | 21 | 29 |
| 7 | 15 | 23 | 31 |

TO BUFFER 33

FLASH MEMORY 23

FROM BUFFER 33

| 0 | 4 | 8 | 12 | 16 | 20 | 24 | 28 |
| 1 | 5 | 9 | 13 | 17 | 21 | 25 | 29 |
| 2 | 6 | 10 | 14 | 18 | 22 | 26 | 30 |
| 3 | 7 | 11 | 15 | 19 | 23 | 27 | 31 |

FLASH MEMORY 24

FROM BUFFER 34

| 32 | 36 | 40 | 44 |
| 33 | 37 | 41 | 45 |
| 34 | 38 | 42 | 46 |
| 35 | 39 | 43 | 47 |

FIG. 5

EP 1 330 715 B1

(a) AFTER1.5 BLOCK WRITING

| LOGISTIC ADDRESS | PARALLE LISM | NUMBER OF NON-PARALLELISM SECTION | FLASH MEMORY DESIGNATION | PHYSICAL ADDRESS | SECTOR ROW MANAGEMENT INFORMATION |
|---|---|---|---|---|---|
| c | 2 | 16 | 0 | G | 0,0,0,.....,0 |
| c+1 | 2 | 16 | 1 | H | 1,1,1,.....,1 |

(b) AFTER 0.5 BLOCK   RE-WRITING

| LOGISTIC ADDRESS | PARALLE LISM | NUMBER OF NON-PARALLELISM SECTION | FLASH MEMORY DESIGNATION | PHYSICAL ADDRESS | SECTOR ROW MANAGEMENT INFORMATION |
|---|---|---|---|---|---|
| c | 1 | 0 | 2 | I | 0,0,0,.....,0 |
| c+1 | 1 | 0 | 3 | J | 0,0,0,.....,0 |

FIG. 6

Z BLOCK

BLOCK B1

BLOCK B2

NUMBER M

M PARALLEL WRITING POSSIBLE ←→ M PARALLEL WRITING IMPOSSIBLE

EP 1 330 715 B1

17

FIG. 7

# FIG. 8

(a)

FLASH MEMORY 21 — B21

| 0 | 8 | 16 | 24 | 32 | 40 | |
|---|---|----|----|----|----|---|
| 2 | 10 | 18 | 26 | 34 | 42 | |
| 4 | 12 | 20 | 28 | 36 | 44 | |
| 6 | 14 | 22 | 30 | 38 | 46 | |

FLASH MEMORY 22 — B22

| 1 | 9 | 17 | 25 | 33 | 41 | |
|---|---|----|----|----|----|---|
| 3 | 11 | 19 | 27 | 35 | 43 | |
| 5 | 13 | 21 | 29 | 37 | 45 | |
| 7 | 15 | 23 | 31 | 39 | 47 | |

FLASH MEMORY 23 — B23

FLASH MEMORY 24 — B24

(b)

B21

| 0 | 8 | 16 | 24 | 32 | 36 | 40 | 44 |
|---|---|----|----|----|----|----|----|
| 2 | 10 | 18 | 26 | 33 | 37 | 41 | 45 |
| 4 | 12 | 20 | 28 | 34 | 38 | 42 | 46 |
| 6 | 14 | 22 | 30 | 35 | 39 | 43 | 47 |

B22

| 1 | 9 | 17 | 25 |
|---|---|----|----|
| 3 | 11 | 19 | 27 |
| 5 | 13 | 21 | 29 |
| 7 | 15 | 23 | 31 |

B23

B24

(c)

B21

| 0 | 4 | 8 | 12 | 16 | 20 | 24 | 28 |
|---|---|---|----|----|----|----|----|
| 1 | 5 | 9 | 13 | 17 | 21 | 25 | 29 |
| 2 | 6 | 10 | 14 | 18 | 22 | 26 | 30 |
| 3 | 7 | 11 | 15 | 19 | 23 | 27 | 31 |

B22

| 32 | 36 | 40 | 44 |
|----|----|----|----|
| 33 | 37 | 41 | 45 |
| 34 | 38 | 42 | 46 |
| 35 | 39 | 43 | 47 |

B23

B24

19

FIG. 9

EP 1 330 715 B1

FIG. 10

| FLASH MEMORY F1 | | | | | B1 |
|---|---|---|---|---|---|
| 0 | 16 | 32 | 48 | | |
| 4 | 20 | 36 | 52 | | |
| 8 | 24 | 40 | 56 | | |
| 12 | 28 | 44 | 60 | | |

| FLASH MEMORY F2 | | | | | B2 |
|---|---|---|---|---|---|
| 1 | 17 | 33 | 49 | | |
| 5 | 21 | 37 | 53 | | |
| 9 | 25 | 41 | 57 | | |
| 13 | 29 | 45 | 61 | | |

| FLASH MEMORY F3 | | | | | B3 |
|---|---|---|---|---|---|
| 2 | 18 | 34 | 50 | | |
| 6 | 22 | 38 | 54 | | |
| 10 | 26 | 42 | 58 | | |
| 14 | 30 | 46 | 62 | | |

| FLASH MEMORY F4 | | | | | B4 |
|---|---|---|---|---|---|
| 3 | 19 | 35 | 51 | | |
| 7 | 23 | 39 | 55 | | |
| 11 | 27 | 43 | 59 | | |
| 15 | 31 | 47 | 63 | | |

M1 ← → M2

**EP 1 330 715 B1**

**REFERENCES CITED IN THE DESCRIPTION**

**Patent documents cited in the description**

- JP 2000132982 A